# EUROPEAN PATENT SPECIFICATION

(11) **EP 0 448 980 B1**
(45) Date of publication and mention of the grant of the patent: **11.06.1997**
(21) Application number: 91103079.9
(22) Date of filing: 01.03.1991
(51) Int. Cl.: G06F 11/20

(54) **Apparatus and method for memory device fault repair**
Vorrichtung und Verfahren für die Beseitigung von Fehlern eines Speichers
Dispositif et procédé de réparation d'erreurs d'une mémoire

(30) Priority: 29.03.1990 US 501064
(43) Date of publication of application: 02.10.1991
(73) Proprietor: TEXAS INSTRUMENTS INCORPORATED, Dallas Texas 75265 (US)
(72) Inventor: McAdams, Hugh, Houston, Texas 75265 (US)
(74) Representative: Leiser, Gottfried, Dipl.-Ing.

(56) References cited:
- EP-A- 0 180 212
- EP-A- 0 202 873

## Description

The present invention relates to semiconductor memory devices and, more particularly, to devices which include repair circuitry for eliminating defects in memory devices, as defined in the pre-characterizing portion of claim 1.

In the fabrication of semiconductor memory devices it is common for an array of memory cells to include one or more defects which prevent the proper performance of the memory circuit. If a type of defect occurs systematically it can often be causally analyzed and designed out. Other defects which are generally not systematic include short circuits between adjacent columns and open circuits within individual columns of memory cells. For analysis purposes the distribution of such defects in a memory device, as well as the distribution of the number of defects among a given production lot, may be considered random so that the yield of good devices in a lot can be modelled according to a Poisson distribution function. Typically, over the period of time that a particular device or family of devices is being produced in a given manufacturing facility the product yield can be improved by removing causes, e.g., particulate matter, of the above-mentioned random defects.

In many fabrication processes the causes of random defects cannot be completely eliminated and it is desirable to further improve the yield of memory devices with redundant circuitry. During testing of a chip defective memory cells can be identified and replaced. Such redundancy techniques are especially suited for semiconductor memories because large numbers of repeating elements are arranged in columns and rows. This array format lends itself to replacement of a defective column or row with any of multiple identical redundant columns or rows.

A redundant circuit scheme may be implemented with a plurality of universal decode circuits connected to the redundant columns. To activate the redundant circuitry appropriate fuses are included for programming individual decoder circuits to be responsive to the addresses of defective memory cells. For example, in dynamic random access memory devices (DRAM's) address integrity can be maintained by simply programming redundant column circuits to respond to defective column addresses. Thus the address of each defective column is assigned to a redundant column circuit. In video and frame memory circuits the replacement procedure may require greater complexity in order to maintain the sequential nature of memory output. See U.S. Patent No. 4,598,388 assigned to the assignee of the present invention.

Semiconductor memories of all types are being made with progressively higher bit densities and smaller cell sizes as the density of integrated memory circuits increases. In 1972 4K bit DRAMs were being designed while in 1982 one megabit devices were planned. Sixteen megabit device densities will become mass produced during the 1990's. As memory capacity continues to progress there must be further improvement in associated performance parameters such as memory access time. As a result memory architectures, which have already become relatively complex, are likely to become even more elaborate as device densities increase.

In order to improve performance it is now commonplace to partition higher density memory arrays into logical data blocks wherein all cells associated with a particular block have common I/O paths. With this arrangement data blocks in an array can be individually accessed. Accordingly, each data word, e.g., possibly 16 or 32 bits wide in a 64 Megabit device, could be stored entirely within one of the blocks so that the entire word can be retrieved from the memory at a given time. Thus there is no loss in availability of data. Advantageously, the blocks in a partitioned array have shorter signal paths, smaller propagation delays and hence faster access times. Further, since only one of many blocks is accessed at a time, the overall device power consumption is also reduced.

Such partitioning requires that at least some of the support circuitry, which functions to select desired memory locations as well as to sense and maintain data states, be repeated for each data block. When the concept of internally partitioning a memory array into smaller logical data blocks was introduced, the memory densities were lower than now achievable and repetition of support circuitry for each data block was an acceptable cost in view of the above-noted performance benefits. That is, the resulting increase in chip size over that required for a slower, more power consuming array design was not critical.

Now, with the development of even denser memory devices, the requisite reduction in feature sizes renders these circuits susceptible to defects caused by particulate matter which previously caused no problems in the fabrication process. Thus with further improvements in circuit density there will be a greater challenge to eliminate random-type defects. Accordingly, greater reliance may be placed on redundant circuit repair schemes.

Published European Patent document EP 0,180,212, A2 discloses a redundancy scheme for a dynamic memory. The memory array is divided into two sectors, each sector containing a portion of each main memory column and a number of spare columns. Means are provided for addressing the main memory columns and the spare columns. When a portion of an addressed main column in the first sector is defective and the remaining portion in the second sector is not defective, the non-defective sector is accessed together with a portion of a spare column. In this way the defective portion can be replaced.

In theory, by providing a sufficient number of redundant circuits on a device, all column defects of the type described above would be repairable in order to maximize the yield of a production lot. Practically, however, cost effectiveness usually dictates that space constraints will limit the quantity of redundant circuits to be placed on each integrated circuit. It is undesirable to increase repair circuitry in proportion to memory density.

In the past redundancy schemes have consisted of only a few extra rows and columns in order to replace up to a predetermined maximum number of defective elements. As long as each logical data block of an internally partitioned memory device included separate address circuitry, the inclusion of sufficient redundant row and column lines within these data blocks did not present difficulties.

Now, due to cost constraints which limit the package size of higher density circuits, it is undesirable to repeat for each memory data block all of the support circuitry needed to replace defective cells. By way of example, redundant column select circuitry need not be repeated for each data block. In fact, it is more space efficient to generate the repair column select signals for all of the data blocks with one series or bank of decoder circuits.

Although sharing of support circuitry among data blocks results in significant saving of space for a circuit layout, it is now recognized that such schemes both complicate and reduce the efficiency of prior art repair techniques.

It is an object of the invention to provide a redundancy scheme which includes a predetermined number of decoder circuits and is more space efficient or more effective than other redundancy schemes having the same number of decoder circuits.

This object is achieved by providing a system as defined above, including the features of the characterizing part of claim 1.

Method claim 4 sets out the method equivalent features of claim 1.

According to the invention a method is provided for maximizing the repair efficiency of a redundancy scheme wherein a given number of redundant columns are allocated to a data block of memory cells. The method involves assigning multiple decoders to each of the redundant select lines so that each line is capable of replacing multiple defective column portions with multiple redundant column portions which are enabled by the same redundant column select line. A nonuniform distribution of decoder circuits among the redundant select lines improves the efficiency of repair and leads to space saving economies.

There is also provided a method for eliminating a defect in a memory device having a logical data block formed with an array of addressable memory cells formed in rows and columns. A defect associated with a first of the columns of cells is eliminated by programming a portion of a first repair column of cells or a portion of a second repair column of cells to be responsive to the addresses of a portion of the cells in the first column. The number of portions of the first repair column of cells which can be allocated to effect multiple repairs among the array columns differs from the number of portions of the second repair column of cells which can be allocated to effect multiple repairs among the array columns.

In a preferred embodiment of the invention there is provided a redundancy scheme, as well as a method for developing a redundancy scheme, resulting in improved device repairability for given space constraints. A memory device is formed with a plurality of data blocks having individual input/output paths. Each block comprises an array of memory cells arranged in addressable rows and columns along row lines and column lines. The array is configured in sub-blocks each comprising a plurality of the memory cells. A second group of memory cells is arranged along the row and column lines of a data block array to provide at least first and second repair columns for the array columns. The device includes row address circuitry for selecting a row of the memory cells, column address circuitry for selecting a column of the memory cells and address repair circuitry.

The address repair circuitry includes a plurality of column repair decoder circuits each connected to a repair column and each programmable with column and row address information corresponding to a section of an array column containing a defective memory cell. With this programming memory cells in a segment of a repair column can replace memory cells in a segment of an array column containing a defective memory cell. The number of decoder circuits allocated to different repair columns is nonuniform.

According to one example of the preferred embodiment a memory device is formed with a plurality of logical data blocks each having individual input/output paths. One of the blocks comprises an array of memory cells arranged in rows and columns and configured in sub-blocks. Each sub-block includes a plurality of memory cells arranged in rows and subcolumns. The block also contains row address circuitry for selecting a row of memory cells and column address circuitry for selecting a memory cell in a column which intersects a selected row. A second group of memory cells is arranged in a plurality of repair columns. Each repair column includes a repair subcolumn for each sub-block of memory cells in the logical data block. Address repair circuitry is provided for replacing subcolumns in the array with repair subcolumns. The repair circuitry includes a plurality of programmable repair column decoders for selecting a repair subcolumn or a segment of multiple repair subcolumns based on row and column address information. The number of decoders allocated to different repair columns is nonuniform.

With this scheme incorporating a level of row decoding in the repair column decoders, portions of redundant columns can be allocated to replace portions of array columns containing defective memory cells. Thus, with multiple decoders, a single redundant column can be utilized to replace multiple defects occuring in different array columns.

### BRIEF DESCRIPTION OF THE DRAWINGS

The invention may be best understood by reference to the following detailed description of a preferred embodiment when read in conjunction with the accompanying drawing, wherein:
Figure 1 is a plan view of a memory device which may incorporate the invention;
Figure 2 illustrates the general layout of a logical data block in the device of Figure 1;
Figure 3 is a partial view of a sub-block of one of the data blocks;
Figure 4 schematically illustrates a fusible comparator decoder according to the invention;
Figure 5 illustrates in block diagram form a column repair scheme according to the invention;
Figures 6A through 6E portray an analysis and methodolgy for improving the achievable level of column repair for a logical data block; and
Figures 7A through 7F illustrate statistical trends relating to device repairability according to the invention.
Figure 8 illustrates a second column repair scheme according to the invention;
Figures 9A - 9F illustrate improvements in probability of defect repair based on nonuniform distributions of decoder circuits; and
Figures 10A - 10C illustrate improvements in the probability of defect repair based on nonuniform distributions of decoder circuits and as a function of the level of row decoding incorporated in the decoder circuitry.

### DETAILED DESCRIPTION OF THE INVENTION

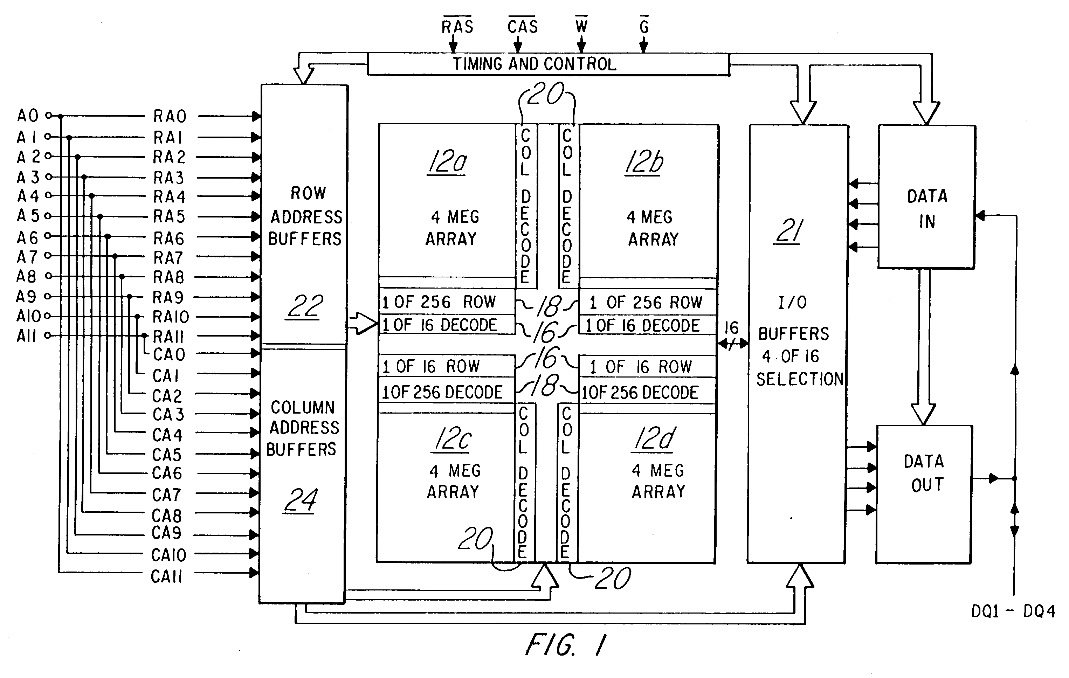

The block diagram of Figure 1 illustrates a semiconductor memory device with which the invention may be practiced. This exemplary device 10 is a DRAM of the so-called 16 Megabit size, having 2²⁴ or 16,777,216 one-transistor storage cells arranged in rows and columns. According to a preferred architecture the device is partitioned into four identical logical data blocks 12, individually designated 12a, 12b, 12c and 12d. Each block 12 is of the four megabit size, comprising 4,194,304 memory cells arranged in an array of 4,096 rows and 1,024 columns C.

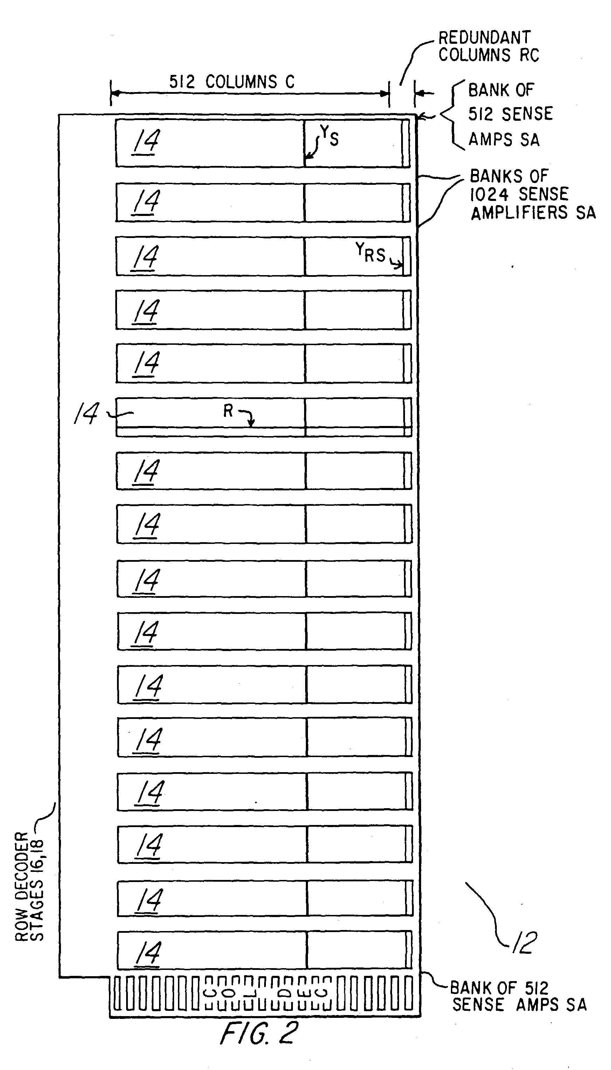

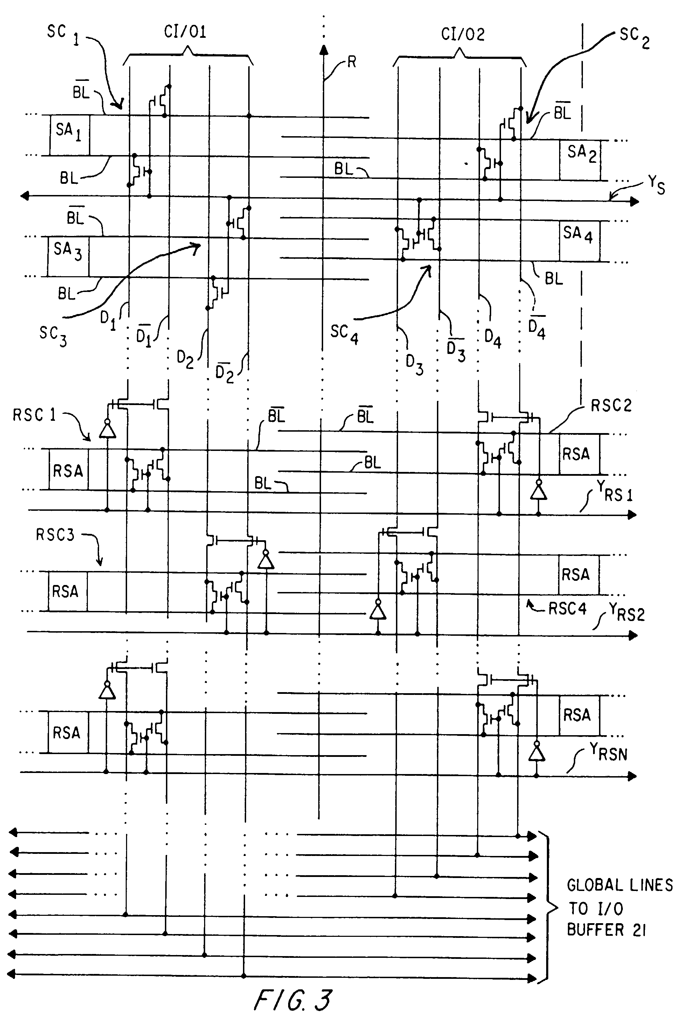

Circuit details of the device 10 which are helpful to understanding the invention are illustrated in Figures 2, 3 and 4. As indicated in Figure 2 each data block 12 is partitioned into sixteen sub-blocks 14. The portion of a column C within each sub-block 14 is formed as a pair of interdigitated subcolumns SC. See Figure 3. Thus 1024 pairs of subcolumns are in each sub-block. Banks of sense amplifiers SA border upper and lower opposing sides of each sub-block.

The partial view of Figure 3 illustrates two adjacent pairs of interdigitated subcolumns SC. The first pair comprises subcolumns SC₁ and SC₂ and the second pair comprises subcolumns SC₃ and SC₄. Each of the pairs of subcolumns is associated with one of two adjacent columns in the sub-block. As is common in high density DRAM devices the subcolumns are arranged in a folded bitline configuration. Thus each subcolumn SC comprises two bitline segments BL and BL_ each containing memory cells and connected to the same sense amplifier SA. The two subcolumns within the sub-block 14 that are associated with the same column C are coupled to different sense amplifiers SA on opposing sides of the sub-block 14. Except for the outermost banks of sense amplifiers in the data block 12 (i.e., those situated along the outer sides of the first and last of the sixteen sub-blocks) each bank of sense amplifiers is shared by sub-columns in an adjacent pair of sub-blocks.

Within each sub-block 14 there are 256 row or word lines R and 256 column select lines Y_{S}. For simplicity of illustration only one row line R and one column select line Y_{S} are shown in Figure 3. A row line is selectable based on row address information input to a one of sixteen row decoder stage 16 and a one of 256 row decoder stage 18. In each data block 12 column address decoders 20 turn on a select line Y_{S} to control read/write data transfer for two columns.

The four sub-columns in a sub-block that are associated with each select line Y_{S} are grouped in pairs for independent and parallel data I/O along one of two, 2-bit wide, local data paths C_{I/0}. Figure 3 illustrates two such paths, designated C_{I/01} and C_{I/02}. Path C_{I/01} comprises two pairs of data lines D₁, D₁_ and D₂, D₂_ each pair providing one bit of information. Similarly path C_{I/02} comprises two pairs of data lines D₃, D₃_ and D₄, D₄_.

Lines D₁, D₂, D₃ and D₄ are connected to receive signals from bitline segments BL and lines D₁_, D₂_, D₃_ and D₄_ are connected to receive complementary signals from bitline segments BL_. Thus each pair of bitlines, in the four sub-columns of a sub-block that are associated with a particular select line Y_{S}, is paired to one of the data line pairs Dᵢ, Dᵢ_. A four-bit wide global data path connects the local paths in each sub-block 14 of a logical data block 12 to the data I/O buffers 21. Thus, when a row of memory cells in a particular sub-block is addressed and a select line Y_{S} is also addressed, data is simultaneously transfered between four memory cells within two adjacent pairs of sub-columns SC and the I/O buffers 21.

For this exemplary DRAM embodiment the row decoding arrangement enables simultaneous transfer of data to or from one sub-block 14 in each of the four data blocks 12 at a given time. The column select arrangement provides × 4 output from each data block 12. Thus the I/O buffers 21 could provide 16 bit parallel I/O.

During a data transfer operation row address signals RA0 through RA11 and column address signals CA0 through CA11 are input in conventional time-multiplexed manner being latched into row and column address buffers 22 and 24 according to timing signals RAS_ and CAS_. See Figure 1. Based on 4 bits of row address information RA0 through RA3, the first row decoder stage 16 selects one of the 16 sub-blocks in each of the data blocks 12. The second row decoder stage 18 selects one of the 256 rows within each selected sub-block based on the remaining 8 bits of row address information RA4 through RA11. The decoder circuitry 20 receives eight bits of column address data, A0 through A7, to provide a logic-high signal along one of the 256 select lines Y_{S} in a data block 12. With this selection the data block provides four bits of data on a pair of 2-bit paths C_{I/0} associated with the accessed sub-block. The next two bits of column address data CA8 and CA9 can be applied in any of several well known decoder circuit arrangements to vary the output of the data block from X 1 to X 4.

The memory array of each data block 12 includes, in addition to the 4,194,304 cells arranged along 1024 columns C, a predetermined number of redundant columns RC. Data I/O of the memory cells in each column RC is controlled by a redundant column select line. One redundant column select line Y_{RS} is illustrated in Figure 2. In principle, the number of redundant columns RC provided in each data block can be sufficient to maximize the yield of a production lot. On the other hand, given typical space constraints, it is desirable that individual data blocks in the device 10 comprise less than five redundant select lines Y_{RS}.

As further illustrated for the sub-block 14 of Figure 3, the redundant columns RC are formed as pairs of redundant sub-columns RSC and a redundant column select line Y_{RS} is connected to access data from each column pair. All of the sub-blocks 14 in a data block 12 include the same number of redundant column selects.

Recalling that the four sub-columns SC associated with each select line Y_{S} in a sub-block 14 are also arranged in pairs, portions of each pair of redundant columns can be wired to replace one or more portions of a pair of subcolumns in a column C. In order to substitute defective memory cells with functioning cells, memory cells in each redundant column are arranged along the 4,096 rows of a data block 12 with each cell connected to a different row line so that all cells in a redundant column can be accessed with the row address decoder stages 16 and 18.

As schematically illustrated in Figure 3, each redundant select line Y_{RS} enables data transfer between each of two constituent subcolumns RSC in a sub-block and a pair of data lines Dᵢ, Dᵢ_ associated with each of the paths C_{I/01} and C_{I/02}. More specifically, a logic-high signal on redundant select line Y_{RS1} connects each pair of folded bitline segments in the two selected redundant sub-columns RSC₁, and RSC₂ to the pairs of data lines D₁, D₁_ and D₄, D₄_. For example, a logic high signal on select line Y_{RS1} will connect the bitline segments of RCS₁ to data lines D₁ and D₁_ and will connect the bitline segments of RCS₂ to data lines D₄ and D₄_. During this transfer period all of the sub-columns SC in the sub-block 14 are disconnected from D₁, D₁_ and D₄, D₄_. Similarly a logic high signal on select line Y_{RS2} will connect the bitline segments of RCS₃ to data lines D₂ and D₂_ and will connect the bitline segments of RCS₄ to data lines D₃ and D₃_.

With this arrangement column repair decode circuitry can advantageously incorporate a level of row decoding in order to replace defective sections of columns C with equivalent sections of redundant columns RC. In a simple implementation of this replacement procedure corresponding sections of columns C and redundant columns RC are responsive to the same level of row decoding. For the device 10 a comparator is programmed to replace a subcolumn pair, or a column segment of subcolumn pairs spanning multiple sub-blocks 14, with a corresponding section of a redundant column.

Such segmentation is useful for allocating two or more portions of the same redundant column for repair of multiple defects occuring in different column segments, e.g., occurring in sections of memory having different column addresses. In the example implementation of the replacement procedure for the device 10, with a given level of row decoding each pair of column sections which is to be replaced must be identifiable with different row address data. When two or more defective sections in different pairs of column sections are identified with the same row address information, a different redundant column RC will be required to replace each of these. Otherwise, as long as sufficient row decoding is provided to associate each of the column sections which is to be replaced with a different section in the repair column, a single redundant column can be segmented to replace all column sections containing the defects in a data block 12. Generally, one redundant column RC can be used to eliminate defects occuring in multiple columns.

The feature of decoding row address information in the column repair circuitry increases the number of repairs which can be made with a given number of redundant columns RC. For example, with a one of fifteen comparator decoder (receiving eight bits of column and three bits of row address information) any one of 8 segments in a redundant column RC can be programmed to replace any one of eight corresponding column segments in any of the four data blocks 12. Alternately, with a one of sixteen comparator decoder (receiving eight bits of column and four bits of row address information) the redundant columns RC can be segmented into sixteen sections each corresponding to a different pair of subcolumns SC in a different one of sixteen sub-blocks 14.

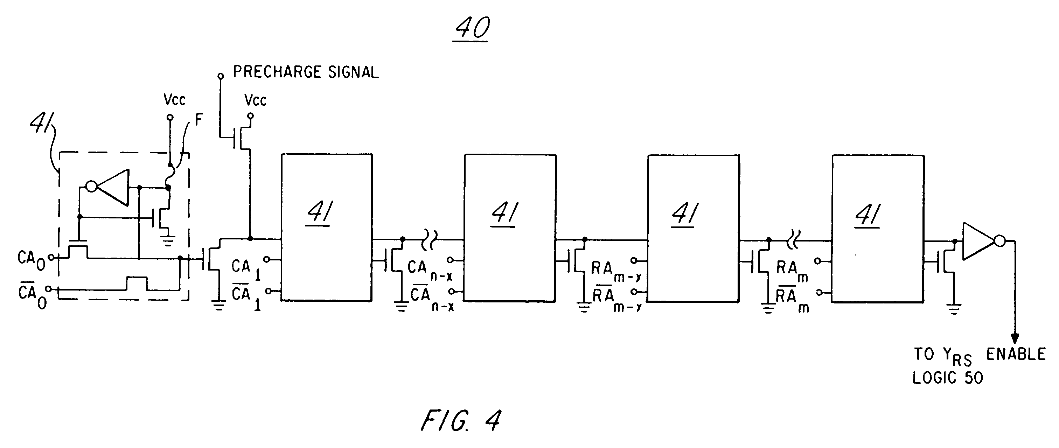

To effect substitution of redundant column cells for defective cells, the column repair decode circuitry includes a plurality of fusible comparator decoders 40. Typically the a decoder 40, shown schematically in Figure 4, will include a number of input circuits 41 each wired to receive an address signal and its complement. Given n column address signals provided to the address buffers 24 and m row address signals provided to the address buffers 22, the decoder 40 includes n-x input circuits for receiving column address signals and m-y input circuits for receiving row address signals. The value of x corresponds to the number of columns C in a data block 12 and the value of y will depend on the desired level of segmentation. Each address input circuit 41 includes a fuse F for programming the decoder with the row or column address information needed to substitute one segment of memory cells along one redundant select line Y_{RS} in a data block for a defective segment of memory cells in a column C of the same data block.

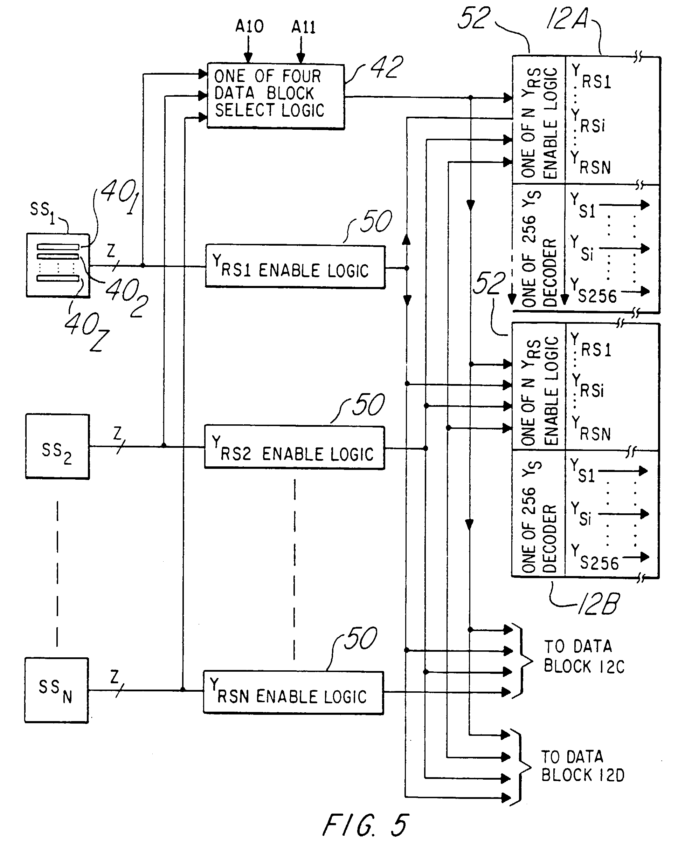

The number of column repairs which can be made on the entire device 10 is equal in count to the total number of comparator decoders. As illustrated schematically in Figure 5 the decoders 40 are arranged in segment select groups SSᵢ. Assuming that each data block 12 has the same number of redundant columns RC, all of the decoders 40 in a particular group SSᵢ are wired to turn on the same redundant select line Y_{RSi} (i = 1,N) in all of the data blocks.

For a given level of row decoding in the decoders 40 any one of a predetermined number of sections within a repair column is addressable in the manner described above to replace a defective section along one of the 256 column select lines in any one of the four data blocks. Thus by programming a decoder 40 a section in a redundant column is definable with a combination of row address information to replace a defective section in one of the data blocks. One of four data block select logic 42 includes a second stage of fusible decoders for identifying the data block to which each decoder 40 is to be dedicated.

All of the second stage decoders in the logic block 42 include input circuits 41, like those of the decoders 40, receiving column address bits CA10 and CA11 to effect the one of four selection. Of course, in other redundancy schemes the decoders of block 42 could provide a higher level of selection in order to allocate sections of the redundant columns RC to portions of the data blocks 12. For example, different redundant columns could be assigned to each half of each data block with the decoders in each group SSᵢ wired to turn on the same redundant select line Y_{RS} in each data half block. With this partitioning the second stage of decoders would include fusible circuits for dedicating each decoder 40 within each group SSᵢ to a particular half block.

In the present embodiment the second stage of decoders 42 provides a one of four selection and the number of segment select groups SSᵢ (i = 1 to N) in Figure 5 is equal to the number, N, of redundant select lines Y_{RS} in each data block 12. The outputs of all the decoders 40 in each segment select group SSᵢ are input to one of N select enable logic circuits 50. When one decoder in a group SSᵢ outputs a logic high signal the select enable logic circuit 50 for that group outputs a logic high signal corresponding to the associated redundant select line Y_{RSi}. With appropriate addressing provided to the decoders 40 and 42, each select enable logic circuit 50 provides a logic-high signal to one redundant select line Y_{RS} in each data block. Figure 5 illustrates for two of the data blocks 12A and 12B combinatorial logic 52 for turning on one of N redundant select lines Y_{RS} based on the output of the data block select logic 42 and the enable logic circuits 50.

According to the invention the repairability of a device containing a given number of random defects can be improved by increasing: the aggregate sum of redundant columns; the quantity of decoders to be provided for each redundant column; and the number of sections into which a column C is to be segmented for individual addressing. Commensurate with an increase in the number of sections into which a redundant column C is addressable for effecting repair of one or more columns C, a higher level of repair can be achieved with fewer redundant columns. Thus the likelihood of device repairability will be improved by increasing the level of decoding as well as the number of decoders associated with each redundant column select line Y_{RS}.

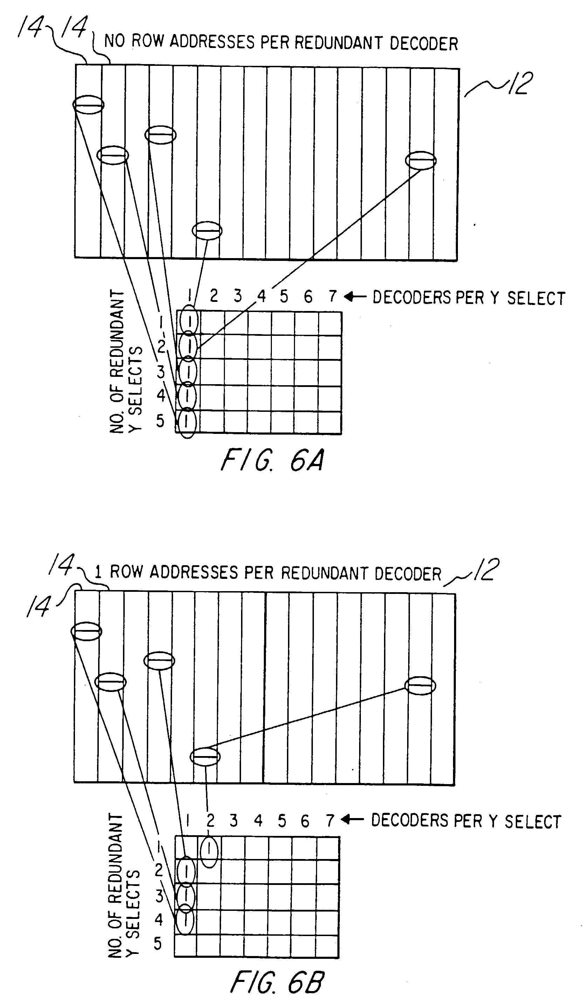

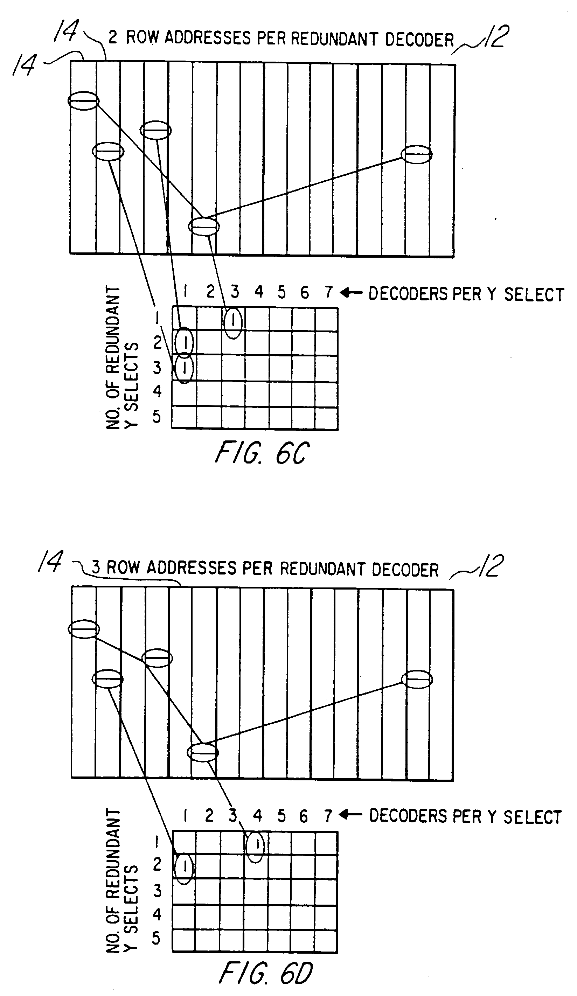

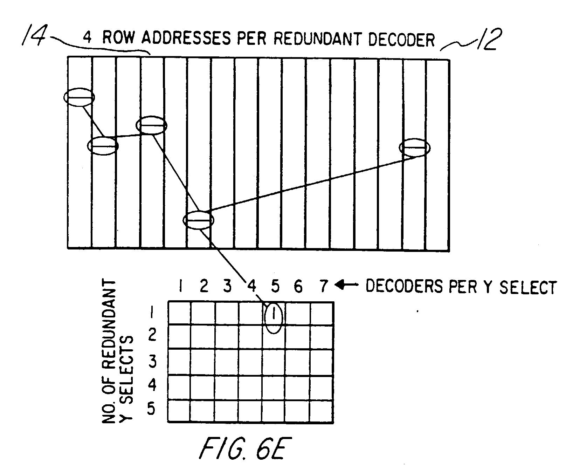

Figures 6A through 6E portray an analysis and methodology for improving the level of defect repair for one data block 12 of the device 10. Given a fixed pattern of five defects each figure depicts an exemplary number of individually addressable sections into which a column C can be segmented to effect replacement with a redundant column RC. For simplicity it is assumed that each defect occurs along a different column select line Y_{S} and in a different one of sixteen sub-blocks 14. For each of the five examples illustrated in Figures 6, as many as five redundant select lines Y_{RS} are available to effect repairs.

When no row decoding is provided by the comparator decoders (Figure 6A) the number of decoders in each segment select group SSᵢ degenerates to one decoder per redundant select line Y_{RS}. When the comparator decoders include no row decode circuitry the columns C cannot be segmented into subsections for individual replacement. Therefore all five redundant select lines must be allocated for repair of the five column defects.

When one bit of row decoding is incorporated in each comparator decoder (Figure 6B) the columns can be segmented in two sections (each section covering eight of the sub-blocks 14) and the segment select groups SSᵢ can include a maximum of two decoders per select line. Full repair is implemented with four select lines Y_{RS} and five decoders. When the comparator decoders perform two bits of row decoding (Figure 6C) the columns are segmented into four sections (each section covering four of the sub-blocks 14) and the segment select groups SSᵢ each include up to three decoders. With the scheme of Figure 6C three select lines Y_{RS} and five decoders will effect full repair of the data block 12.

Provision of three row address bits to the comparator decoders segments the columns into eight sections (Figure 6D) and permits four decoders per select line Y_{RS}. Repair of all five defects will be realized with only two select lines Y_{RS} wherein at least one segment select group SSᵢ includes four decoders. Ultimately, as shown in Figure 6E, the comparator decoders can resolve the columns into sixteen sections (each corresponding to one sub-block 14) with four bits of row address information. When one segment select group includes five comparator decoders all five repairs can be performed with one select line Y_{RS}.

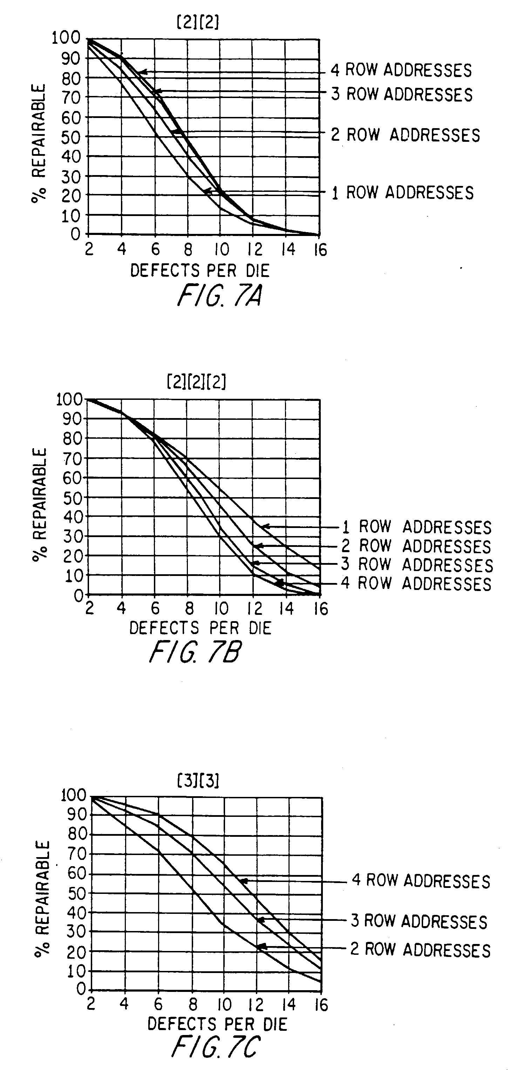

Given a fixed number of redundant select lines Y_{RS} the level of repairabilty for the entire device 10 can increase when both the count of comparator decoders in all of the segment select groups increases and the level of row decoding in the comparator decoders increases. Figures 7A through 7F illustrate trends in probability of complete repair for various device defect levels as the level of row decoding in the comparator decoders increases from zero to four bits. The numbers in brackets, e.g., [2] [2], above each graph indicate the number of decoders 40 assigned to each segment select group SSᵢ. A bracketed number is provided for each segment select group.

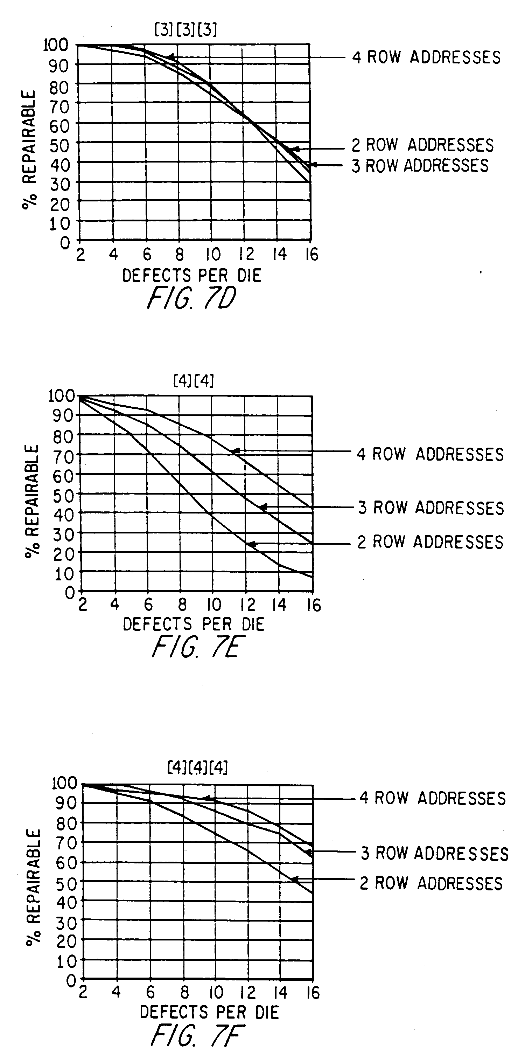

Thus Figure 7A illustrates improvements in repairability (as a function of row address inputs to the decoders 40) for an embodiment having two segment select groups and two decoders 40 per segment select group. Figure 7B suggests that for the embodiment of three segment select groups, each including two decoders 40, repairability may not improve with a higher degree of segmentation. Figures 7D through 7F indicate improved repairability with higher levels of segmentation. The figures illustrate that repairability according to the invention is dependent on device architecture and improvements may not always be obtained. Comparison of Figures 7A, 7D and 7F suggests that device repairability improves as the number of decoders 40 per segment select group and the level of decoding both increase.

The data of Figures 6 and 7 are, of course, specific to the exemplary device as well as the defect level. In the same manner inferences can be drawn from analysis of other device designs to identify trends in device repairability. With reference to Figure 5 and in view of this data, one general approach for implementing a column repair scheme is to provide each segment select group SSᵢ with the same number, Z, of decoders 40, and to incorporate a sufficient level of row decoding in each decoder 40 to achieve a satisfactory level of repairability.

For the simple example of Figures 6 a repair scheme for the entire device could comprise two redundant select lines Y_{RS} each coupled to a different one of two segment select groups SSᵢ. The groups SSᵢ would comprise four decoders 40 with all of the decoders receiving four bits of row address information to segment each redundant column into sixteen sections. A satisfactory level of repairability may be achievable with other combinations, e.g., three decoders per segment select group SSᵢ with each decoder receiving three bits of row address information.

The selection of two different repair schemes which exhibit comparable levels of repairability may be based in part on space constraints. The determination of an acceptable level of repair should be made in view of yield projections as well as space constraints to avoid over design. When space constraints and other economies are not critical factors the device can simply incorporate a sufficient number of decoders uniformly distributed among the segment select groups to assure ample repairability.

From the above discussion it is clear that one method of maximizing repair efficiency with a given number of redundant select lines in each data block is to assign multiple decoders to each of the select lines so that each line is capable of replacing up to a predetermined number of defective column portions with segments taken from a single redundant column. Thus when presented with the problem of maximizing production yield one approach would be to place as many redundant column select lines on a chip as permitted by the space constraints; and uniformly distributing the decoders among the redundant lines so that each line is capable of repairing the same number of defects.

While at first blush this appears to be a reasonable approach to improving repairable yield it is now apparent that such an approach will not always provide an optimum column redundancy scheme for maximizing the repairable yield. With increased complexity and density of memory devices the above-described method of improving repair efficiency may not maximumize repairable yield while utilizing as little additional space as necessary.

With probability statistics several inferences can be drawn to predict the quantity and arrangement of redundant column select lines and decoders which will provide optimum repairability. In fact, from a repairable yield perspective, given a predetermined number of redundant column select lines and a predetermined number of decoders it can be more effective to couple fewer decoders to one or more redundant select lines Y_{RS}, i.e., to turn on each redundant column RC, than to others. Further, a nonuniform distribution of a fixed number of decoders among a predetermined number of select lines Y_{RS} can be of equal or greater effectiveness than a uniform distribution of the same fixed number of decoders over a larger number of select lines Y_{RS}. In other circumstances, depending in part on the memory architecture, it will be more effective to add an additional redundant column select line with a single decoder to a data block than it would be to add additional decoders to a fewer number of redundant column select lines.

In a second general approach for implementing a column repair scheme several parameters can be individually or collectively varied to provide a redundancy scheme having an improved level of repairability and a more space efficient layout. Significant parameters include:
(1) the quantity and distribution of comparator decoders among the segment select groups SSᵢ;
(2) the number of sections into which a redundant column RC is addressable to replace a column C and, hence, the level of row decoding incorporated within the fusible decode circuitry;
(3) the number of redundant select lines Y_{RS}; and
(4) the number of redundant columns RC coupled to each select line.

The aggregate sum of redundant columns, the quantity of decoders to be provided for each redundant column and the number of sections into which a column C is to be segmented for individual addressing, can all be optimized with probability techniques based on an assumed number of defects per device.

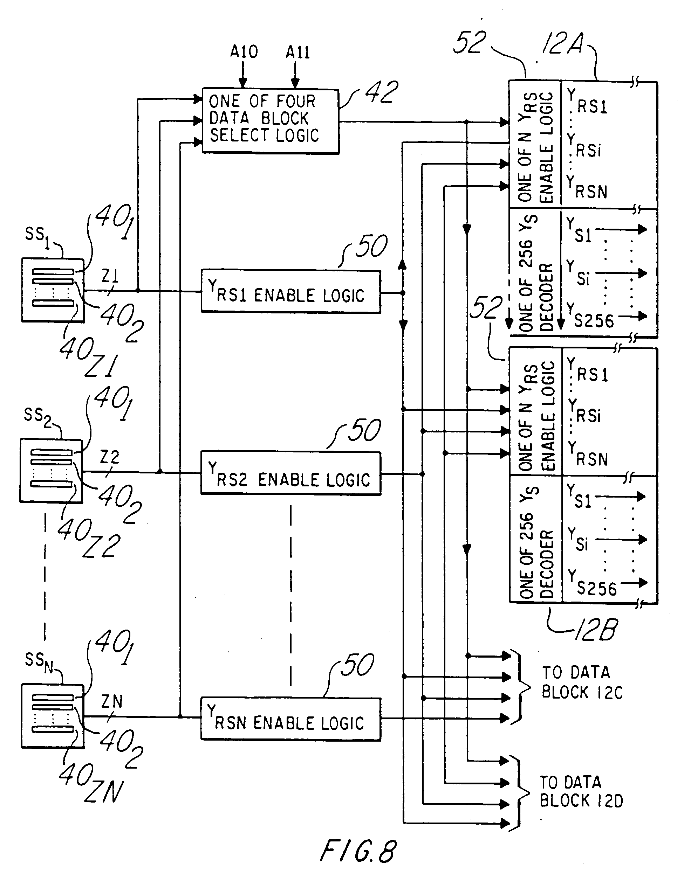

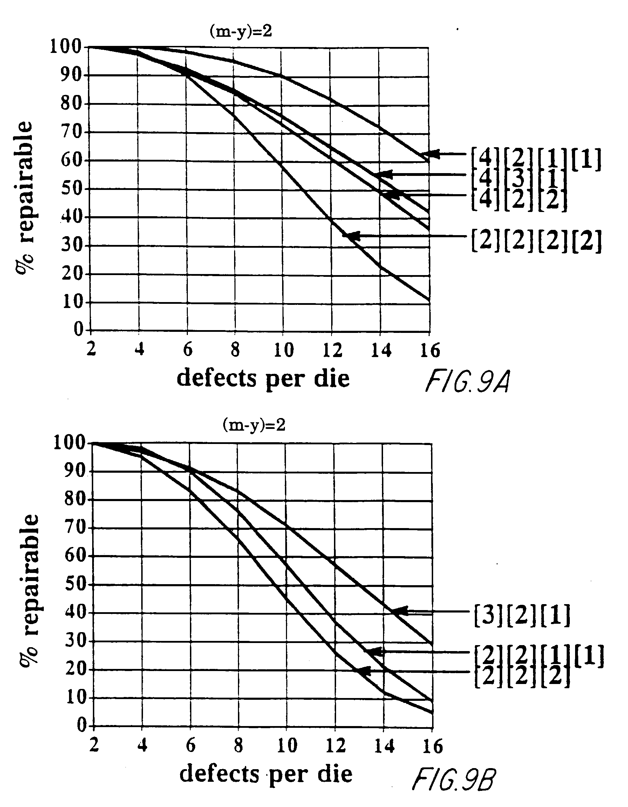

In addition to trends such as illustrated in Figures 7 the count of comparator decoders in different segment select groups SSᵢ can be varied with respect to one another to further optimize the level of repairability for a given number of redundant select lines Y_{RS}. Figure 8 illustrates a column repair scheme similar to that of Figure 5 but wherein the distribution of comparator decoders 40 among segment select groups SSᵢ is nonuniform. That is, Z1, Z2 ... ZN are not all of the same value.

Based on random defect distributions and prediction analyses it has been determined that by allocating decoder circuits to repair columns with a nonuniform distribution, the overall number of decoders can be reduced without significant loss in repairability. For some device embodiments and design constraints a distribution can be found which provides an improved level of repairability over the Figure 5 uniform distribution of decoders among segment select groups.

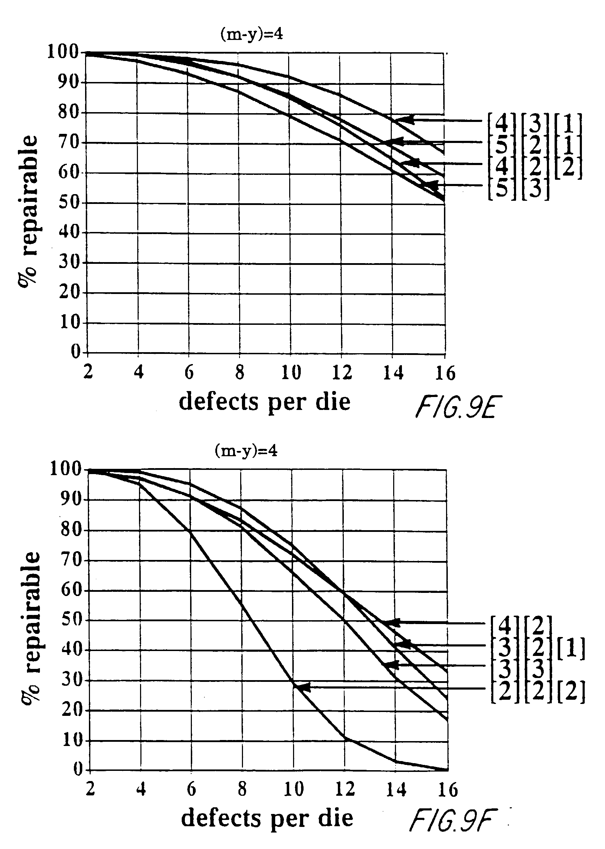

Figures 9A - 9F illustrate improvements in probability of repair based on the distribution of decoder circuits. The figures incorporate notation similar to that of Figure 7. That is, the numbers in brackets, e.g., [4] [2] [1] [1], indicate the number of decoders assigned to each segment select group SSᵢ. The number of brackets associated with a particular curve in a figure correspond to the number of segment select groups as well as the number of redundant select lines Y_{RS}. The prediction analyses assume that each select line Y_{RS} turns on two redundant subcolumns RSC in each sub-block of a data block 12.

By way of example, Figures 9A and 9B illustrate improvements in repairability for a repair scheme wherein all of the decoder circuits include (m - y) = 2 input circuits for receiving two row address signals. As illustrated in Figure 6C, this level of row decoding segments the columns into four sections each spanning four sub-blocks 14. Figure 9A indicates, for six or more defects per die, that a nonuniform distribution of eight decoders among three redundant select lines, i.e., [4] [3] [1], provides a higher level of repairablility than a uniform distribution of eight decoders among four redundant select lines, i.e., [2] [2] [2] [2]. The highest level of repairability is achieved with a nonuniform allocation of the eight decoders among four select lines, i.e., [4] [2] [1] [1]. Figure 9B illustrates similar trends for a total of seven decoder circuits with the combination [3] [2] [1] providing the best overall repairability.

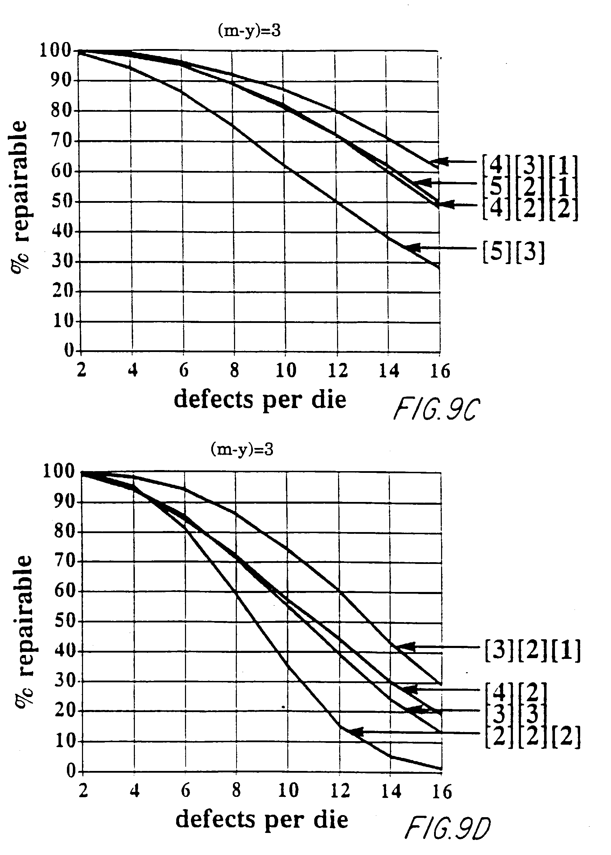

Figures 9C and 9D portray similar trends for a repair scheme wherein all of the decoder circuits include (m - y) = 3 input circuits for receiving three row address signals. As illustrated in Figure 6D, this level of row decoding segments the columns into eight sections each spanning two sub-blocks 14. Figures 9E and 9F again illustrate similar trends for a repair scheme wherein all of the decoder circuits include (m - y) = 4 input circuits for receiving four row address signals. As illustrated in Figure 6E, this level of row decoding segments the columns into sixteen sections each corresonding to one sub-block 14. Generally Figures 9A - 9D confirm that the nonuniform distribution of decoders can improve repairability.

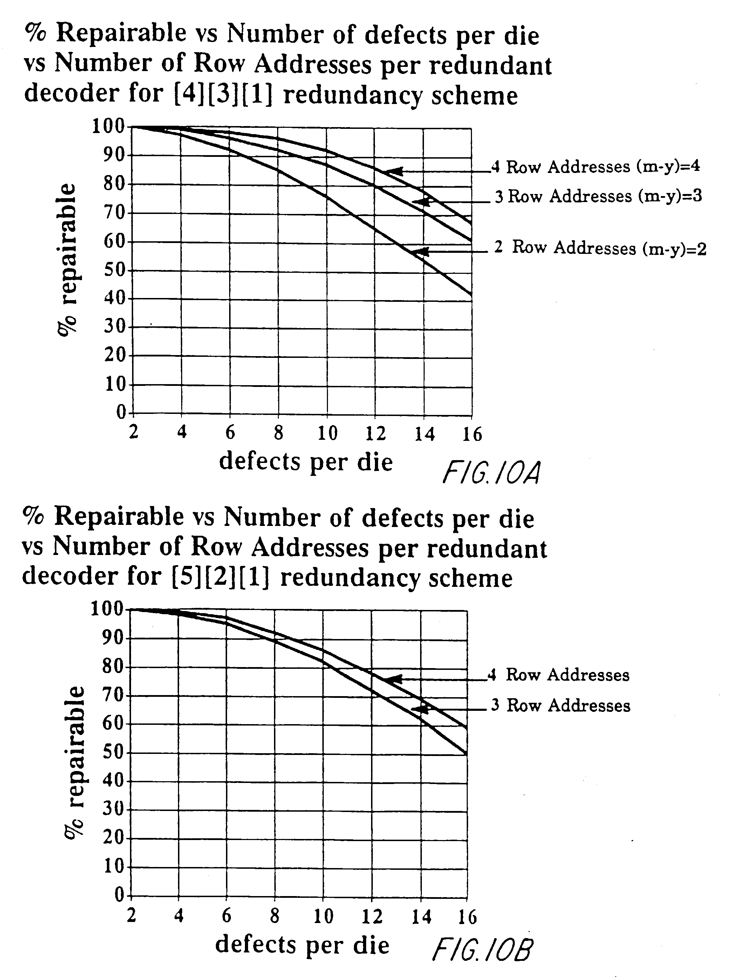

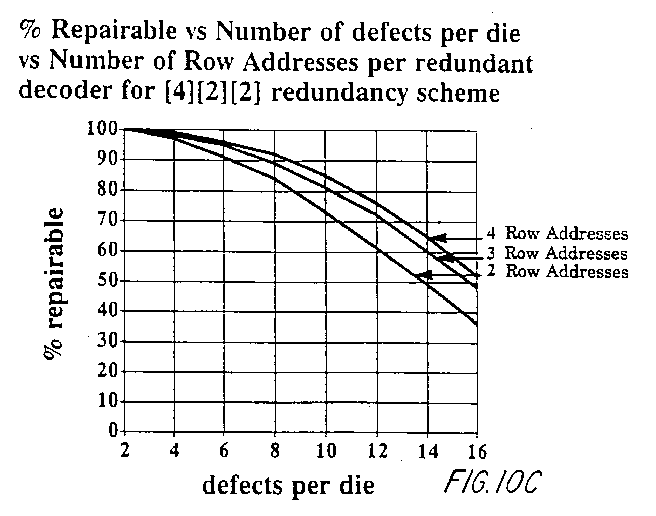

With fixed space constraints the level of segmentation and the distribution of decoders among segment select groups can be optimized in combination to provide an improved level of repair over that achievable with the uniform distribution of decoders. Figures 10A and 10B illustrate improvements in the [4] [3] [1] combination and the [4] [2] [2] combination, respectively, (depicted in Figures 9A, 9C and 9E) as (m - y) increases from two to four. Figure 10C illustrates a similar trend for the [5] [2] [1] combination of Figures 9B, 9D and 9F as (m - y) increases from two to four. Transposing the bracket notation of Figures 9 and 10 has no effect on the level of repairability, i.e., [1] [2] is equivalent to [2] [1]; and [3] [1] [4] is equivalent to [4] [3] [1].

The implementation of these concepts to provide an optimum redundancy scheme will depend on device architecture, the desired level of repairability and the cost/benefit factors associated with decoder geometry and other space constraints in the device layout. Table One illustrates numerous combinations of nonuniform decoder distributions which may be useful for improving the defect repairability or space efficiency of a defect repair scheme. The Table presents these combinations in an ascending sequence for embodiments comprising up to six redundant column select lines Y_{RS} and up to five redundant decoders 40 per select line Y_{RS}. A continuation up to any desired level is apparent from the pattern established in Table One.

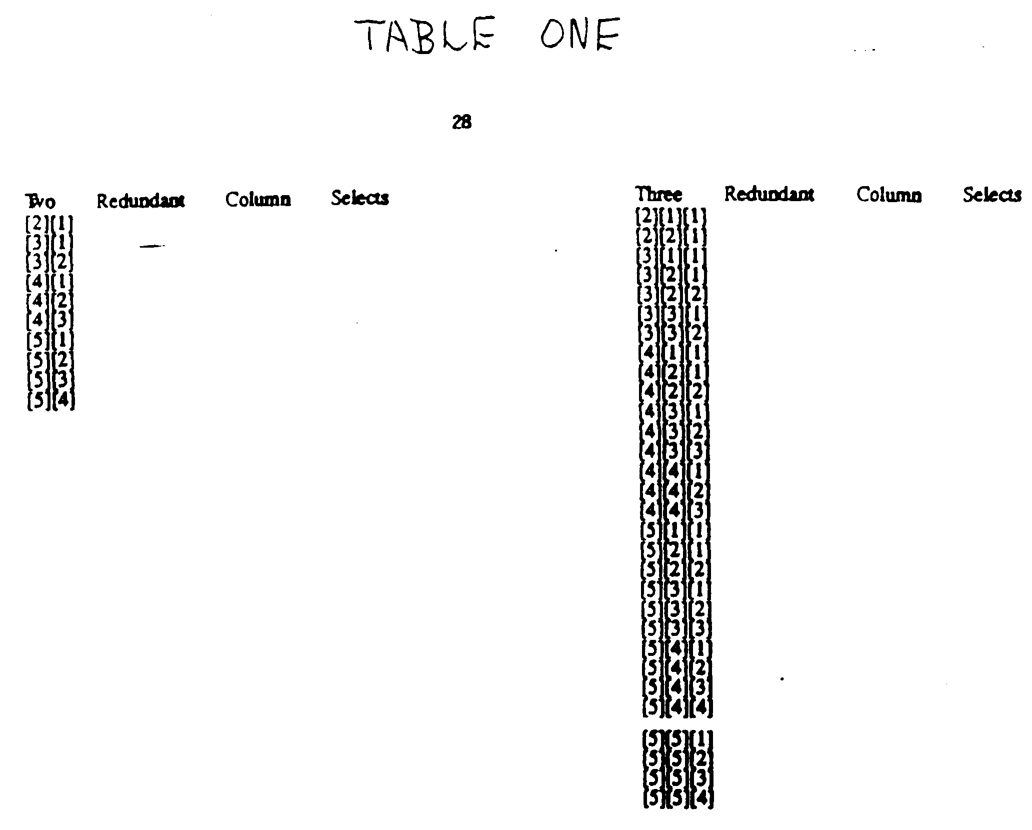

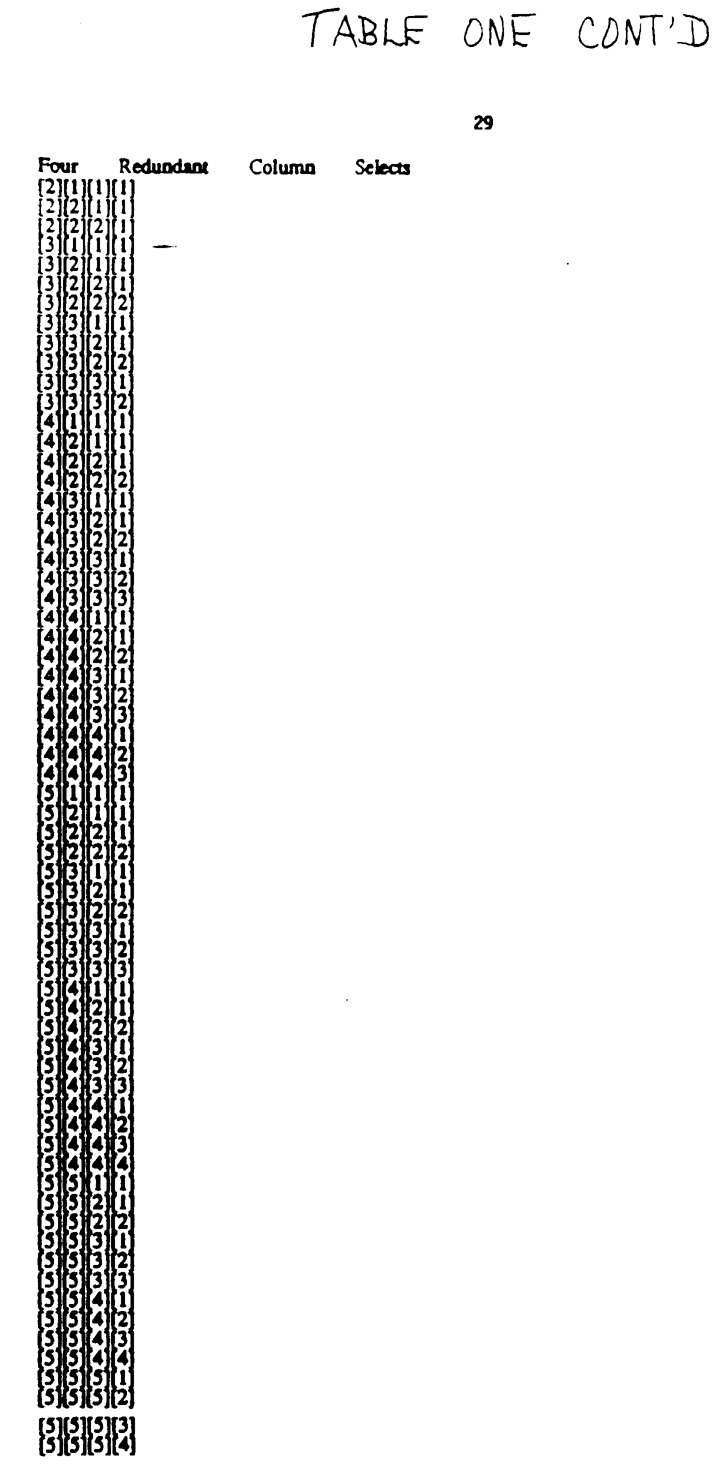

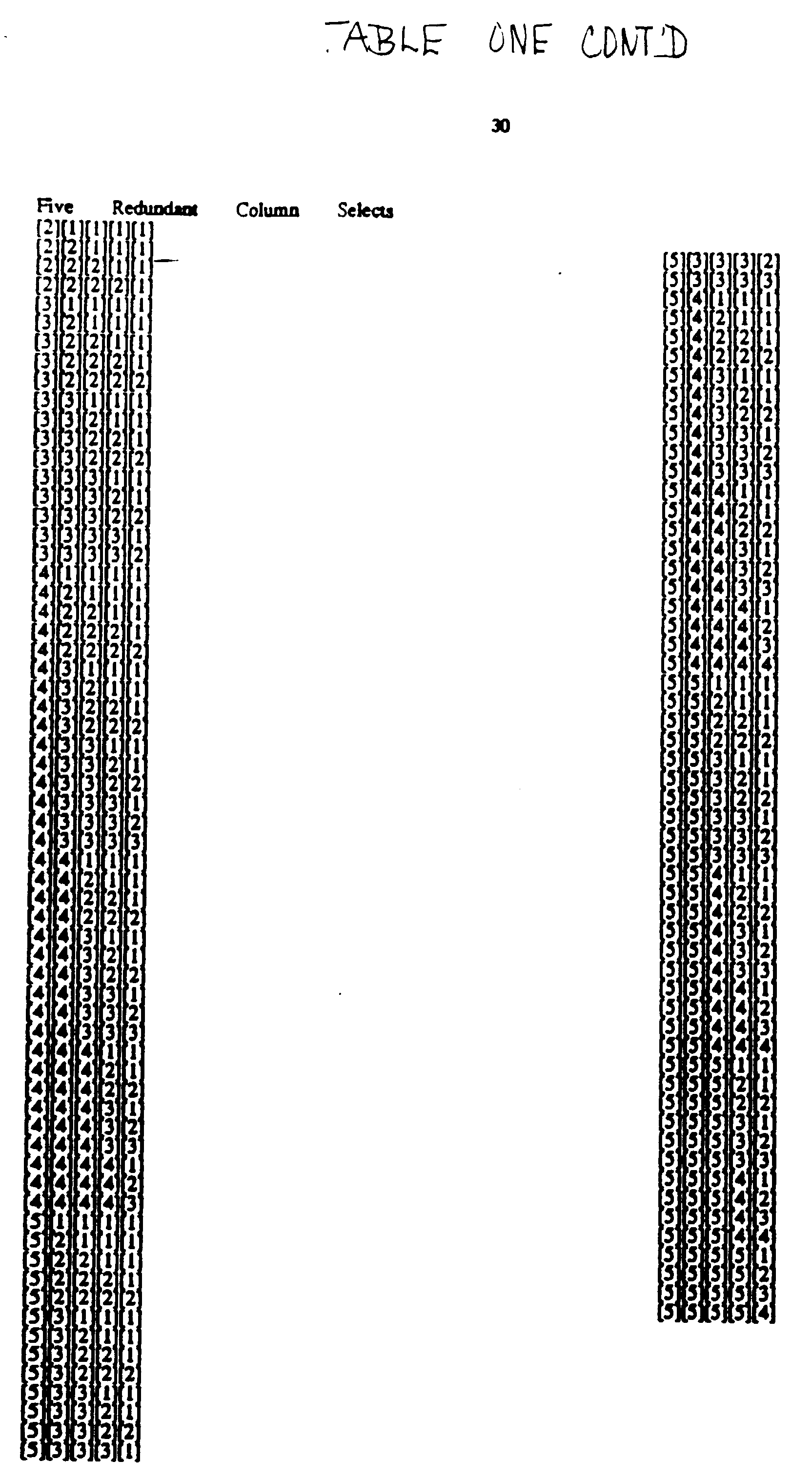

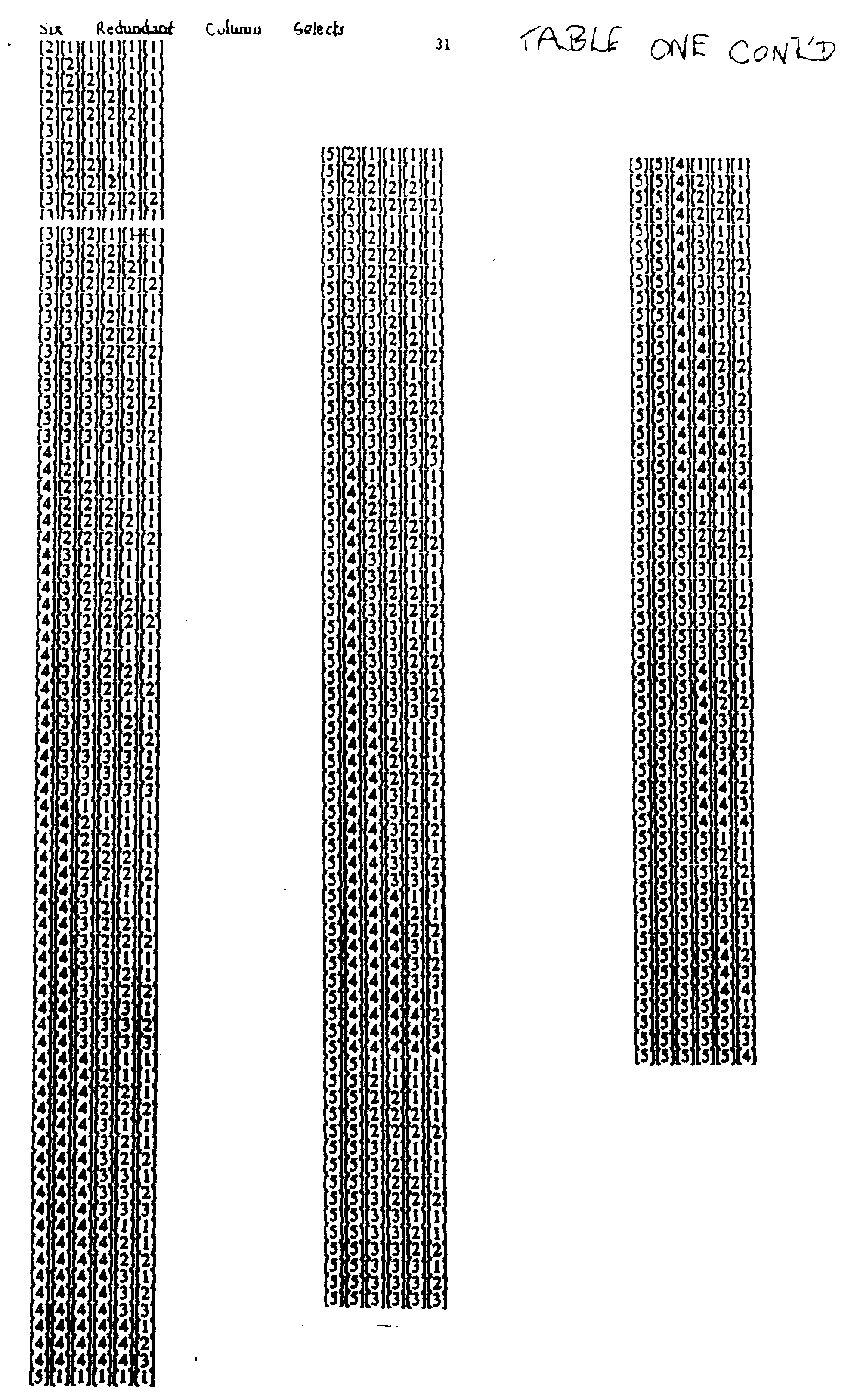

From the above description it can be seen that a method of maximizing repair efficiency with a given number of redundant select lines in each data block involves assigning multiple decoders to each of the redundant select lines so that each line is capable of replacing multiple defective column portions with redundant column portions that are coupled to the same select line. A nonuniform distribution of decoder circuits among the select lines may further improve the efficiency of repair and lead to space saving economies.

The definitions of rows, row lines, columns, subcolumns and select lines as used to describe certain embodiments of the invention are not to be construed as limiting the invention. Rather, it is recognized that the many possible variations in device architecture will alter the meanings of these and other terms. Further, the exemplary application of the inventive concepts to what is commonly referred to as column repair does not limit the invention to such. As an example, for various device types, e.g., SRAMs, as well as for simpler device architectures, redundant row repair schemes could include the feature of incorporating column address information in the decoder repair circuitry to replace sections of rows of memory cells containing defects with sections of redundant rows. Thus in defining the invention the meanings of the terms column and row as used in this detailed description and the claims which follow are not limited based on geometric orientation or electrical connection and, unless otherwise restricted, the meanings of these terms are interchangeable.

In describing the feature of decoding row address information in the column repair circuitry the terms section, portion and segment as used herein with regard to a column C or a redundant column RC, each comprehend less than a full column of memory cells and fewer than all of the memory cells connected along one column select line. When interchanging the meanings of the terms row and column the terms section, portion and segment define less than a full row of memory cells or fewer than all of the memory cells along a particular row line.

With consideration to the space constraints present on high density, e.g., sixteen Megabit, devices, redundancy schemes can be optimized for space efficiency as well as repairability. The desirability of minimizing the geometric size of a redundancy scheme stems from the space consuming nature of fuses which are used to program the decoders 40. Even though portions of device circuitry are based on sub-micron line widths, fuse lines for redundant decoders are significantly wider, e.g., one to two microns on center. Further, to avoid electrical shorts between fuses, as well as between fuse lines and adjacent circuitry, layouts have spaced fuse lines seven microns on center from adjacent fuse lines or other conductors. Thus the space requirement for fusible decoders can be substantial and will increase in direct relation to the level of decoding incorporated to replace defective column sections with corresponding sections of redundant columns.

For these reasons it may be undesirable to repeat for each logical data block all of the programmable support circuitry, e.g., the decoders 40, needed to replace defective cells. Indeed, it has been illustrated that the sharing of redundant column select signals among the data blocks provides economies in the device layout. On the other hand, this sharing complicates the redundancy schemes and so reduces the efficiency of repair that, that, overall, a larger number of redundant columns may be needed to offset the loss in efficiency of repair. That is, when the redundant column decode circuits are each common to all of the data blocks, at least one column in each data block will share the same select line signal. Segmentation of repair lines overcomes this disadvantage.

In a simple embodiment of the invention, when a defective section in one data block is to be replaced with a redundant section, corresponding sections in the other data blocks could also be replaced by redundant sections that are coupled to the same decoder. Thus replacement of a column section along one data block could require replacement of all corresponding column sections in the other data blocks. More certainly, when a redundant column section in each of several different data blocks shares a common redundant decoder, the assignment of one of those redundant column sections to a specific address constrains assignment of the other redundant column sections in the other data blocks to the same address. With this address dedication scheme the usefulness of a redundant column section in a particular data block which could otherwise be used to replace a defective column section may appear lost.

In redundancy schemes wherein redundant column decoders are shared among several data blocks, the efficiency of column repair can be further improved upon by incorporating additional information within the comparator decoders, e.g., data block designation, to further define where a defect is located and dedicate a portion of only one redundant column each time a decoder is programmed. With this approach a segment of a redundant column will not be used to replace a good segment of a column C. Rather, an addressed segment of a redundant column will be activated only when the corresponding defective segment of a single column, i.e., in only one data block, is addressed.

To implement this feature in the device 10 the comparator decoders 40 of Figures 4 and 5 would include additional fusing and address inputs in order to respond to two bits of data block address information (CA10, CA11). With such modification repair segments located in different data blocks, comprising redundant subcolumns connected to the same select line Y_{RS} and identifiable with the same row address information, can be assigned different column address information so that each may be used to replace a defective column portion having a different column address, i.e., A0 through A7.

While the invention has been shown and described with reference to a particular memory device and specific embodiments of repair schemes, it will be understood by those skilled in the art that many changes in design and detail may be made without departing from the scope of the invention which is limited only by the claims which follow.

## Claims

1. A memory device (10) comprising:
a memory array having a plurality of memory cells arranged in addressable rows and columns, the memory array being divided into a plurality of data blocks (12a-d), each having an associated input/output path (CI/01, CI/02), each data block (12a-d) including a plurality of sub-blocks (14);
a group of redundant memory cells arranged in at least two redundant columns (RC), each redundant column (RC) being associated with a sub-block (14) of the memory array;
address repair circuitry including a plurality of decoders (16, 18, 20) for addressing redundant (RC) columns, each decoder being programmable with address information corresponding to a portion of an array column containing a defective cell, the decoder being capable of replacing the defective cell with a memory cell of a redundant column (RC);
and characterised in that a first redundant column of said at least two redundant columns (RC) is connected to a different number of decoders than a second redundant column of said at least two redundant columns (RC), such that the distribution of decoders dedicated to different redundant columns is non-uniform, the decoders being capable of selecting the number of portions of the first and second redundant columns (RC) for effecting the repair.

2. The memory device (10) of Claim 1, wherein each decoder is programmable for selecting a redundant column (RC) according to the address of an array column.

3. The memory device (10) of any preceding claim, wherein each redundant column (RC) includes a redundant sub-column for each sub-block (14) of memory cells of the memory array.

4. A method for eliminating a defect in a memory device (10) having a logical block (band) comprising an array of addressable memory cells formed in rows and columns, a group of redundant cells arranged in at least two redundant columns (RC), and wherein the defect to be eliminated is associated with a first of the columns of cells, the method comprising the steps of:
providing a first redundant column of said at least two redundant columns (RC) of cells portions of which can be allocated to effect multiple repairs among the array columns;
providing a second redundant column of said at least two redundant columns (RC) of cells portions of which can be allocated to effect multiple repairs among the array columns;
coupling a first quantity of decoder circuits (16, 18, 20) to the first redundant column (RC), and
coupling a second quantity of decoder circuits (16, 18, 20) to the second redundant column,
and characterised in that the first redundant column (RC) is connected to a different number of decoders than the second redundant column (RC), such that the distribution of decoders dedicated to different redundant columns (RC) is non-uniform, the decoders being capable of selecting the number of portions of the first and second columns (RC) for effecting repair.

## Patentansprüche

1. Speichervorrichtung (10) mit:
einer Speichermatrix mit mehreren in adressierbaren Zeilen und Spalten angeordneten Speicherzellen, wobei die Speichermatrix in mehrere Datenblöcke (12a-d) unterteilt ist, die jeweils einen zugeordneten Eingangs-/Ausgangs-Pfad (CI/O1, CI/O2) aufweisen, wobei jeder Datenblock (12a-d) mehrere Teilblöcke (14) enthält;
einer Gruppe von Redundanzspeicherzellen, die in wenigstens zwei Redundanzspalten (RC) angeordnet sind, wobei jeder Redundanzspalte (RC) ein Teilblock (14) der Speichermatrix zugeordnet ist,
einer Adressenreparaturschaltung mit mehreren Dekodierern (16, 18, 20) zum Adressieren von Redundanzspalten (RC), wobei jeder Dekodierer mit einer Adresseninformation entsprechend einem Abschnitt einer Matrixspalte programmierbar ist, die eine fehlerhafte Zelle enthält, und der Dekodierer die fehlerhafte Zelle mit einer Speicherzelle einer Redundanzspalte (RC) ersetzen kann;
dadurch gekennzeichnet, daß eine erste Redundanzspalte (RC) der wenigstens zwei Redundanzspalten mit einer anderen Anzahl von Dekodierern als eine zweite Redundanzspalte (RC) der wenigstens zwei Redundanzspalten verbunden ist, so daß die Verteilung der den verschiedenen Redundanzspalten zugeordneten Dekodierer ungleichmäßig ist, wobei die Dekodierer die Anzahl von Abschnitten der ersten und zweiten Redundanzspalten (RC) zur Durchführung der Reparatur auswählen können.

2. Speichervorrichtung (10) nach Anspruch 1, bei welcher jeder Dekodierer so programmierbar ist, daß eine Redundanzspalte (RC) entsprechend der Adresse einer Matrixspalte ausgewählt wird.

3. Speichervorrichtung (10) nach einem der vorhergehenden Ansprüche, bei welcher jede Redundanzspalte (RC) eine redundante Teilspalte für jeden Teilblock (14) aus Speicherzellen der Speichermatrix enthält.

4. Verfahren zum Eliminieren eines Fehlers in einer Speichervorrichtung (10) mit einem logischen Block (Band) aus einer Matrix adressierbarer Speicherzellen, die in Zeilen und Spalten angeordnet sind, wobei eine Gruppe von Redundanz zellen in wenigstens zwei Redundanzspalten (RC) angeordnet ist und wobei der zu eliminierende Fehler einer ersten Zellenspalte zugeordnet ist, wobei das Verfahren folgende Schritte enthält:
Vorsehen einer ersten Redundanzspalte der wenigstens zwei Redundanzspalten (RC) aus Zellen, von der Abschnitte der Durchführung mehrfacher Reparaturen unter den Matrixspalten zugeordnet werden können;
Vorsehen einer zweiten Redundanzspalte der wenigstens zwei Redundanzspalten (RC) aus Zellen, von der Abschnitte der Durchführung mehrfacher Reparaturen unter den Matrixspalten zugeordnet werden können;
Verbinden einer ersten Menge von Dekodierschaltungen (16, 18, 20) mit der ersten Redundanzspalte (RC), und
Verbinden einer zweiten Menge von Dekodierschaltungen (16, 18, 20) mit der zweiten Redundanzspalte,
dadurch gekennzeichnet, daß die erste Redundanzspalte (RC) an eine andere Anzahl von Dekodierern als die zweite Redundanzspalte (RC) angeschlossen ist, so daß die Verteilung der den verschiedenen Redundanz spalten (RC) zugeordneten Dekodierern ungleichmäßig ist, wobei die Dekodierer die Anzahl von Abschnitten der ersten und zweiten Spalten (RC) für die Durchführung der Reparatur auswählen können.

## Revendications

1. Dispositif de mémoire (10) comprenant un réseau de mémoire ayant plusieurs cellules de mémoire agencées en lignes et colonnes adressables, le réseau de mémoire étant divisé en plusieurs blocs de données (12a-d), comprenant chacun des voies d'entrée/sortie associées (CI/01, CI/02), chacun des blocs de données (12a-d) comprenant plusieurs sous-blocs (14), un groupe de cellules de mémoire redondantes agencées en au moins deux colonnes redondantes (RC), chaque colonne redondante (RC) étant associée avec un sous-bloc (14) du réseau de mémoire, des circuits de réparation d'adresses comprenant plusieurs décodeurs (16, 18, 20) pour adresser des colonnes redondantes (RC), chaque décodeur étant programmable avec des informations d'adresses correspondant à une partie d'une colonne de réseau contenant une cellule défectueuse, le décodeur étant capable de remplacer la cellule défectueuse par une cellule de mémoire d'une colonne redondante (RC), et caractérisé en ce qu'une première colonne redondante desdites au moins deux colonnes redondantes (RC) est reliée à un nombre de décodeurs différent de celui d'une seconde colonne redondante desdites au moins deux colonnes redondantes (RC), de telle manière que la distribution de décodeurs alloués aux différentes colonnes redondantes est non uniforme, les décodeurs étant capables de sélectionner le nombre de parties des première et seconde colonnes redondantes (RC) pour effectuer la réparation.

2. Dispositif de mémoire (10) selon la revendication 1, dans lequel chaque décodeur est programmable pour sélectionner une colonne redondante (RC) selon l'adresse d'une colonne de réseau.

3. Dispositif de mémoire (10) selon l'une quelconque des revendications précédentes, dans lequel chaque colonne redondante (RC) comprend une sous-colonne redondante pour chaque sous-bloc (14) des cellules de mémoire du réseau de mémoire.

4. Procédé pour supprimer un défaut dans un dispositif de mémoire (10) ayant un bloc (bande) logique comprenant un réseau de cellules de mémoire adressables formé en lignes et colonnes, un groupe de cellules redondantes agencées en au moins deux colonnes redondantes (RC), et dans lequel le défaut à supprimer est associé à une première des colonnes de cellules, le procédé comprenant les étapes consistant à :
- fournir une première colonne redondante desdites au moins deux colonnes redondantes (RC) de parties de cellules qui peuvent être attribuées pour effectuer plusieurs réparations parmi les colonnes de réseau,
- fournir une seconde colonne redondante desdites au moins deux colonnes redondantes (RC) de parties de cellules qui peuvent être attribuées pour effectuer plusieurs réparations parmi les colonnes de réseau,
- coupler une première quantité de circuits de décodeurs (16, 18, 20) à la première colonne redondante (RC), et
- coupler une seconde quantité de circuits de décodeurs (16, 18, 20) à la seconde colonne redondante,
et caractérisé en ce que la première colonne redondante (RC) est reliée à un nombre de décodeurs différent de celui de la seconde colonne redondante (RC), de telle manière que la distribution de décodeurs alloués à des colonnes redondantes (RC) différentes est non uniforme, les décodeurs étant capables de sélectionner le nombre de parties des première et seconde colonnes (RC) pour effectuer une réparation.
